# EUROPEAN PATENT SPECIFICATION

(11) **EP 1 768 175 B1**
(45) Date of publication and mention of the grant of the patent: **15.05.2019**
(21) Application number: 05743708.9
(22) Date of filing: 30.05.2005
(51) Int. Cl.: H01L 21/76

(54) **METHOD FOR FORMING TRENCH ISOLATION STRUCTURE**
VERFAHREN ZUR BILDUNG EINER GRABENISOLATIONSSTRUKTUR
MÉTHODE DE FORMATION DE STRUCTURE D'ISOLATION DE TRANCHÉE

(30) Priority: 04.06.2004 JP 2004167435
(43) Date of publication of application: 28.03.2007
(73) Proprietor: Merck Patent GmbH, 64293 Darmstadt (DE)
(72) Inventor: NAGURA, Teruno, Chiba 276-0033 (JP); SHIMIZU, Yasuo, Tokyo 185-0034 (JP); ICHIYAMA, Masaaki, Shizuoka 437-1412 (JP)
(74) Representative: Isenbruck, Günter
(86) International application number: PCT/JP2005/009891
(87) International publication number: WO 2005/119758

(56) References cited:
- WO-A1-2004/079819
- JP-A- 8 097 277
- JP-A- 10 303 289
- JP-A- 11 307 626
- JP-A- 2001 308 090
- JP-A- 2002 043 408
- JP-A- 2002 088 156
- JP-A- 2002 367 980
- JP-A- 2003 031 796
- US-A1- 2002 123 206
- US-A1- 2002 127 817
- US-A1- 2002 168 873
- US-A1- 2003 011 019
- JUNG-SIK CHOI ET AL: "A shallow trench isolation using novel polysilazane-based sog for deep submicron technologies and beyond", 2003 IEEE INTERNATIONAL SYMPOSIUM ON SEMICONDUCTOR MANUFACTURING. CONFERENCE PROCEEDINGS. ( ISSM 2003 ). SAN JOSE, CA, SEPT. 30 - OCT. 2, 2003; [IEEE INTERNATIONAL SYMPOSIUM ON SEMICONDUCTOR MANUFACTURING], NEW YORK, NY : IEEE, US LNKD- DOI:10.1109/I, 30 September 2003 (2003-09-30), pages 419-422, XP010667486, ISBN: 978-0-7803-7894-0
- STANLEY WOLF ED - STANLEY WOLF: "Chapter 9: Shallow Trench Isolation (STI)", 1 May 2002 (2002-05-01), SILICON PROCESSING FOR THE VLSI ERA - VOL. 4 DEEP-SUBMICRON PROCESS TECHNOLOGY, LATTICE PRESS, US, PAGE(S) 433 - 474, XP009113311, ISBN: 978-0-9616721-7-1 * pages 446-455, chapter 9.4 * * pages 458-462, chapter 9.5.3 *

## Description

### TECHNICAL FIELD

The present invention relates to a method for forming a trench isolation structure in an electronic device. More specifically, the present invention relates to a method for forming a trench isolation structure using a silicon-containing polymer for insulation in electronic devices in the production of electronic devices such as semiconductor devices, wherein a silicon nitride liner film is oxidized at a high temperature.

### BACKGROUND ART

In general, in electronic devices such as semiconductor devices, semiconductor elements, for example, transistors, resistances, and other elements, are disposed on a substrate. These semiconductor elements should be electrically insulated from each other. Accordingly, a region for isolating elements from each other should be provided between mutually adjacent elements. This region is called an isolation region. In general, this isolation region has hitherto been provided by selectively forming an insulating film on a surface of a semiconductor substrate.

On the other hand, in the field of electronic devices, in recent years, the density and degree of integration have become increased. The increased density and degree of integration makes it difficult to form an isolation structure having fineness which matches the necessary degree of integration, leading to a demand for a novel isolation structure which can meet the need. A trench isolation structure is one of such structures. This structure is such that fine grooves are provided on a surface of a semiconductor substrate and an insulating material is filled into the interior of the grooves to electrically isolate each part between elements provided respectively on both sides of the groove. This structure for element isolation can realize a narrower isolation region than that achieved by the conventional method and thus is an element isolation structure effective for realizing a high degree of integration which has recently been required.

Methods for forming such trench isolation structures include CVD (chemical vapor deposition) and high-density plasma CVD (high density plasma CVD) (see, for example, patent document 1). These methods, however, are disadvantageous in that voids are formed within the grooves and the shape of the grooves formed in the substrate is changed. These structural defects are causative of a deterioration in physical strength of the substrate and insulating properties.

On the other hand, in order to improve the trench groove filling property, a method has been studied in which, after coating of silicon hydroxide as a solution, the formed coating film is converted to silicon dioxide by heat treatment (see, for example, patent document 1). In this method, however, in converting silicon hydroxide to silicon dioxide, volume shrinkage sometimes occurs resulting in cracking.

In order to suppress such cracking, a method has been proposed in which polysilazane is used instead of silicon hydroxide (for example, patent documents 1 and 2). In these methods, cracking attributable to volume shrinkage is prevented by using polysilazane of which the volume shrinkage in the conversion to silicon dioxide is smaller. According to studies conducted by the present inventors, however, these methods still have room for improvement.

In view of the above background, the present inventors have found that the regulation of a prebaking temperature in the formation of a trench isolation structure using polysilazane can reduce the volume shrinkage of silicon dioxide and consequently can form a good trench isolation structure (patent document 4). This method is one method that can prevent the occurrence of structure defects.

Further method of filling trench isolation grooves with silicon-containing polymers are known from US 2002/0168873 A1, WO 2004/079819 or US 2002/0127817 A1.
Patent document 1: Patent No. 3178412 (paragraphs 0005 to 0016)
Patent document 2: Japanese Patent Laid-Open No. 308090/2001
Patent document 3: Japanese Patent Laid-Open No. 88156/2002
Patent document 4: Japanese Patent Laid-Open No. 273519/2004

### DISCLOSURE OF THE INVENTION

### PROBLEMS TO BE SOLVED BY THE INVENTION

The present invention has been made in view of the above problems of the prior art and provides a method for trench isolation structure formation, which comprises covering a surface of a substrate with groove(s) formed therein with a silicon nitride liner film, coating a silicon-containing polymer solution onto the silicon nitride liner film and heating the coated substrate at a high temperature to oxidize at least a part of the silicon nitride liner film, thereby allowing volume shrinkage caused upon the conversion of the silicon-containing polymer to silicon dioxide (that is, a siliceous film) to be alleviated by the oxidized film.

### MEANS FOR SOLVING THE PROBLEMS

According to the present invention, there is provided a first method for forming a trench isolation structure, comprising the steps of:
forming, on a silicon substrate, trench isolation groove(s) having a surface continuously coated with a silicon nitride liner film;
coating the substrate with a solution of a silicon-containing polymer, selected from the group consisting of polysilazanes, silsesquioxane hydrides, and mixtures thereof, in an organic solvent to form a silicon-containing polymer film; and
curing by heat treating the coated substrate at a temperature of from 1000°C to 1200°C to convert the silicon-containing polymer film to a silicon dioxide film, wherein the thickness of the silicon nitride liner film is 8 to 50 nm, wherein at least part of the silicon nitride liner film is oxidized up to no less than 1.0 nm from the surface of the silicon nitride liner film on its side not in contact with the substrate, and wherein the thickness of the silicon nitride liner film is increased by 1.3 times or more by the heat treatment.

### EFFECT OF THE INVENTION

In the method for trench isolation structure formation, a base material with a siliceous film can be produced which is free from voids or cracks within the groove and has excellent adhesion between the substrate and the siliceous film formed on the substrate, that is, causes no deterioration in the performance of a semiconductor element and has excellent mechanical strength.

### BEST MODE FOR CARRYING OUT THE INVENTION

### Method for trench isolation structure formation

In the method for trench isolation structure formation, a trench isolation structure is formed by carrying out the following steps in the following order.
(A) Groove forming step
(B) Coating step
(C) Curing step

Each step will be described in detail.

### (A) Groove forming step

In the method according to the present invention, trench isolation groove(s) are first formed on a silicon substrate. The groove may be formed by any method described, for example, in patent document 1 or 2. A method for groove formation will be specifically described below.

At the outset, a silicon dioxide film is formed on a surface of a silicon substrate, for example, by thermal oxidation. In this case, the thickness of the silicon dioxide film is generally 5 to 30 nm.

If necessary, a silicon nitride film is formed on the formed silicon dioxide film, for example, by vacuum CVD. This silicon nitride film can function as a mask in the step of etching which will be described later, or as a stop layer in the step of polishing which will be described later. In this case, the silicon nitride film is generally formed to a thickness of 100 to 400 nm.

A photoresist is coated on the formed silicon dioxide film or silicon nitride film. The photoresist film is if necessary dried or cured and is then exposed and developed in a desired pattern to form a pattern. The exposure can be carried out by any method such as mask exposure or scanning exposure. The photoresist may also be any desired one selected from the viewpoint of resolution and the like.

The silicon nitride film and the silicon dioxide film underlying the silicon nitride film are sequentially etched using the photoresist film as a mask. A desired pattern is formed in the silicon nitride film and the silicon dioxide film by this etching.

The silicon substrate is dry etched using the patterned silicon nitride film and silicon dioxide film as a mask to form trench isolation groove(s).

The width of the trench isolation groove is determined by the exposure pattern of the photoresist film. The trench isolation groove in the semiconductor element varies depending upon the contemplated semiconductor element. However, the width may be generally 0.02 to 10 µm, preferably 0.05 to 5 µm, and the depth may be 200 to 1000 nm, preferably 300 to 700 nm. In the method according to the present invention, as compared with the conventional method for trench isolation structure formation, narrower and deeper burying can be uniformly realized, and, thus, the method according to the present invention is suitable for the formation of a narrower and deeper trench isolation structure.

A silicon nitride liner film is further formed on the surface of the substrate with groove(s) formed therein, for example, by CVD. The silicon nitride liner film continuously covers the surface of the substrate including the inner side of the groove, whereby, for example, the oxidation of silicon constituting the substrate can be prevented. Further, at least the surface part of the silicon liner film is oxidized by the step of curing which will be described later and consequently functions to relax the stress within the groove and, at the same time, to improve the adhesion between the substrate and the silicon dioxide (siliceous film) formed within the groove. Accordingly, the silicon nitride liner film should continuously cover the whole substrate surface including the interior of the groove, particularly including the inner wall surface. The silicon nitride liner film is sometimes exposed to a high-temperature steam atmosphere in the step of curing which will be described later. In this case, the silicon nitride liner film is oxidized. Accordingly, the thickness of the silicon nitride liner film is preferably large from the viewpoint of preventing the progress of the oxidation to the underlying silicon substrate which deteriorates device properties. On the other hand, since the width of the trench groove formed in the substrate is narrow, the thickness of the silicon nitride liner film is preferably small from the viewpoint of preventing such an unfavorable phenomenon that the trench groove is filled with the silicon nitride liner film and, consequently, the fine trench isolation structure disappears. For the above reason, the thickness of the silicon nitride liner film is generally 8 to 50 nm, preferably 10 to 30 nm.

The use of silicon nitride, for example, as a stop layer in the step of polishing has hitherto been known. The silicon nitride film used as the stop layer is not provided within the groove, particularly on the inner wall. It is not known that silicon nitride is oxidized in a temperature range used in the method according to the present invention. Further, the above effect of oxidized silicon nitride is surprising.

If necessary, a polysilicon film can be formed, for example, by CVD, on the surface of the substrate with the silicon nitride liner film formed therein. This polysilicon film has the following functions: (i) the polysilicon film is converted to a silicon dioxide film in the curing step, and volume expansion generated in this case can relax stress generated between the trenches in the conversion of the polysilazane to silicon dioxide; and (ii) the adhesion between the polysilazane film and the substrate can be improved. The thickness of the polysilicon film is generally 1 to 50 nm, preferably 3 to 20 nm. When this polysilicon film is used, there is a tendency that the volume expansion of the polysilicon film in addition to the volume expansion of the silicon nitride liner film contributes to significantly improved stress relaxation and adhesion.

### (B) Coating step

Next, a coating film of a silicon-containing polymer as a material for a siliceous film is formed on the silicon substrate having in its surface groove(s) formed by the groove forming step. This silicon-containing polymer is selected from the group consisting of polysilazanes, silsesquioxane hydrides, and a mixture thereof.

The polysilazane usable in the method according to the present invention is not particularly limited, and polysilazanes described in patent document 1 or 2 can be used. One example of a method for preparing a polysilazane solution usable herein will be described.

Dichlorosilane having a purity of not less than 99% is poured into dehydrated pyridine of which the temperature has been regulated to a range of -20 to 20°C with stirring.

Subsequently, the temperature of the solution is regulated to -20 to 20°C, and ammonia having a purity of not less than 99% is poured into the solution with stirring. Here a crude polysilazane and ammonium chloride as a by-product is produced.

Ammonium chloride produced by the reaction is removed by filtration.

The filtrate is heated to 30 to 150°C, and the molecular weight of the polysilazane is regulated to a range of 1500 to 15000 in terms of the weight average molecular weight while removing the residual ammonia.

The organic solvent is heated to 30 to 50°C, and the residual pyridine is removed by distillation under a reduced pressure of not more than 50 mmHg. Organic solvents usable herein include (i) aromatic compounds, for example, benzene, toluene, xylene, ethylbenzene, diethylbenzene, trimethylbenzene, triethylbenzen, and decahydronaphthalene, (ii) chain saturated hydrocarbons, for example, n-pentane, i-pentane, n-hexane, i-hexane, n-heptane, i-heptane, n-octane, i-octane, n-nonane, i-nonane, n-decane, and i-decane, (iii) cyclic saturated hydrocarbons, for example, cyclohexane, ethylcyclohexane, methylcyclohexane, and p-menthane, (iv) cyclic unsaturated hydrocarbons, for example, cyclohexene and dipentene (limonene), (v) ethers, for example, dipropyl ether, dibutyl ether, and anisole, (vi) esters, for example, n-butyl acetate, i-butyl acetate, n-amyl acetate, and i-amyl acetate, and (vii) ketones, for example, methyl i-butyl ketone.

Pyridine is removed by the distillation under the reduced pressure. At the same time, the organic solvent is also removed to regulate the polysilazane concentration to generally a range of 5 to 30% by weight.

The polysilazane solution is subjected to cycle filtration through a filter with a filtration accuracy of not more than 0.1 µm to reduce coarse particles having a particle diameter of not less than 0.2 µm to 50 particles/cc or less.

The above method is one example of a method for preparing a polysilazane solution, and the method for polysilazane solution preparation is not particulary limited to this method. A method may also be adopted in which a solid polysilazane is obtained and, in use, is generally dissolved or dispersed in the above-described suitable solvent to a concentration of 5 to 30% by weight. The solution concentration should be properly regulated, for example, by the thickness of the finally formed polysilazane coating film.

The silsesquioxane hydride usable in the present invention is also not particularly limited, and silsesquioxane hydrides described, for example, in patent document 3 may be used. As with the case of the polysilazane solution, the silsesquioxane hydride may be dissolved in an organic solvent to prepare a solution having a concentration of 5 to 30% by weight from which coarse particles are then removed before use.

The silicon-containing polymer solution thus prepared may be coated on the substrate by any desired method. Specific examples of coating methods include spin coating, curtain coating, dip coating and the like. Among them, spin coating is particularly preferred, for example, from the viewpoint of evenness of the coated film surface.

In order to realize both the trench groove filling property after coating the silicon-containing polymer solution and the flatness of the silicon-containing polymer coating film surface, the thickness of the coated silicon-containing polymer coating film is preferably in the range of 0.8 to two times based on the whole of the trench isolation groove formed in the groove forming step, that is, the total thickness of the silicon substrate, the silicon dioxide film, and the silicon nitride film.

Coating conditions vary depending, for example, upon the concentration of the silicon-containing polymer solution, solvent, or coating method. Coating conditions will be described by taking spin coating as an example.

In recent years, in order to improve the yield of production, in many cases, elements have become formed on a large substrate. Spin coating involving a combination of a plurality of stages is effective for evenly forming a polysilazane coating film on a silicon substrate having a size of 8 in. or larger.

At the outset, a silicon-containing polymer solution in an amount of 0.5 to 20 cc per silicon substrate is generally dropped in the center part of the silicon substrate, or several parts including the center part so that a coating film is averagely formed on the whole substrate surface.

Next, in order to spread the dropped silicon-containing polymer solution onto the whole silicon substrate surface, the silicon substrate is rotated at a relatively low speed for a short period of time, for example, at a rotation speed of 50 to 500 rpm for 0.5 to 10 sec (prespinning).

Next, the silicon substrate is rotated at a relatively high speed, for example, at a rotation speed of 500 to 4500 rpm for 0.5 to 800 sec to bring the thickness of the coating film to a desired value (main spinning).

Further, in order to reduce bulging of the silicon-containing polymer coating film at a part around the silicon substrate and, at the same time, to remove the solvent in the silicon-containing polymer coating film as much as possible, the silicon substrate is rotated at a rotation speed which is higher by 500 rpm or more than the main spinning rotation speed, for example, at a rotation speed of 1000 to 5000 rpm for 5 to 300 sec (final spinning).

These coating conditions are properly regulated depending, for example, upon the size of the substrate used and the performance of the contemplated semiconductor element.

### (C) Curing step

After coating of the silicon-containing polymer solution, the coating is if necessary subjected to prebaking step (which will be described later). The silicon-containing polymer coating film is then converted to a silicon dioxide film for curing. Further, the whole substrate is heated to oxidize the silicon nitride liner film. In this case, in general, the whole substrate is placed in a curing oven or the like and is heated.

Curing is generally carried out using a curing oven or a hot plate under a steam-containing inert gas or oxygen atmosphere. The steam is important for satisfactorily converting the silicon-containing polymer to silicon dioxide, and the concentration of the steam is preferably not less than 30%, more preferably not less than 50%, most preferably not less than 70%. In particular, when the steam concentration is not less than 80%, the conversion of the silicon-containing polymer to silicon dioxide can easily proceed and, consequently, advantageously, defects such as voids are reduced and the properties of the silicon dioxide film can be improved. When an inert gas is used as the atmosphere gas, for example, nitrogen, argon, or helium is used.

Temperature conditions for curing vary depending upon the type of the silicon-containing polymer and a combination of steps (which will be described later). However, when the temperature is higher, the silicon nitride liner film is more likely to be oxidized. As a result, the expansion of the film thickness is increased , and the effect of improving the film quality becomes better. On the other hand, when the temperature is lower, the adverse effect of oxidation of the silicon substrate or a change in crystal structure on device properties is likely to be lowered. From this viewpoint, in the method according to the present invention, curing is carried out in one stage of from 1000°C to 1200°C. In this case, the temperature rise time for the temperature to reach the target value is generally 1 to 100°C/min, and the curing time after the temperature reaches the target value, is generally 1 min to 10 hr, preferably 15 min to 3 hr. If necessary, the curing temperature or the composition of the curing atmosphere can be varied stepwise.

Upon heating, the silicon-containing polymer is converted to silicon dioxide and thus to form a siliceous film, and, at the same time, at least a part of the silicon nitride liner film is oxidized. In general, the silicon nitride liner film is oxidized from its surface on the side not in contact with the substrate (hereinafter referred to as an outer surface). When oxidation proceeds, silicon nitride is oxidized to a deeper position. Here it is considered that the silicon nitride liner film undergoes volume expansion as a result of the oxidation and, consequently, the denseness in the interior of the trench is improved and the adhesion between the siliceous film and the substrate is improved. In order to attain the above effect, silicon nitride is oxidized by 1.0 nm or more from the outer surface. Preferably, the oxidation is allowed to proceed to up to 90% of the thickness of the silicon nitride liner film, more preferably up to 80% of the thickness of the silicon nitride liner film, from the viewpoint of avoiding oxidation of the silicon substrate underlying the silicon nitride liner film and thus avoiding a deterioration in the properties of the device. When the thickness of the silicon nitride liner film is small, preferably, oxidation of the silicon nitride liner film in its part between the substrate and the position which is not less than 1 nm from the substrate is avoided.

Upon heating, the thickness of the silicon nitride liner film is increased. The film thickness after heating is not less than 1.3 times larger, more preferably not less than 1.5 times larger, than the film thickness before heating.

When the polysilicon film is provided on the silicon nitride liner film, the polysilicon film is generally oxidized simultaneously with the silicon nitride liner film. The polysilicon film may be oxidized either partially or entirely. The polysilicon film is preferably oxidized entirely from the viewpoint of ensuring insulating properties.

In the method for trench isolation structure formation according to the present invention, the above-described steps (A) to (C) are indispensable. If necessary, further steps may be carried out in combination with these steps. Steps which may be combined with the above steps are as follows.

### (a) Prebaking step

The substrate coated with the silicon-containing polymer solution may be prebaked prior to the curing step. This step is carried out for completely removing the solvent contained in the silicon-containing polymer coating film and for preliminarily curing the silicon-containing polymer coating film. In particular, in the method for trench isolation structure formation according to the present invention using the silicon-containing polymer, prebaking treatment can improve the denseness of the siliceous film. Accordingly, preferably, the prebaking step is used in combination with steps (A) to (C).

In the prebaking step in the prior art, a method has been adopted in which heating is carried at a substantially constant temperature. In the conventional method, the coating film shrinks during curing, resulting in the formation of a recess in the trench isolation groove part and the occurrence of voids in the interior of the groove.

When the prebaking treatment is carried out in the method according to the present invention, preferably, the temperature in the prebaking step is controlled and prebaking is carried out while raising the temperature with time. In this case, the temperature in the prebaking step is generally in a temperature range of 50°C to 400°C, preferably 100 to 300°C. The time required for the prebaking step is generally 10 sec to 30 min, preferably 30 sec to 10 min.

Methods for raising the temperature with time in the prebaking step include a method in which the temperature of the atmosphere in which the substrate is placed is raised stepwise, or a method in which the temperature is raised monotonically. The highest prebaking temperature in the prebaking step is generally set at a temperature above the boiling point of the solvent used in the polysilazane solution from the viewpoint of removing the solvent from the film.

In the method in which the temperature in the prebaking step is raised stepwise, a series of procedures consisting of keeping the temperature of the substrate at a specific given temperature for a given period of time, for example, at a temperature T1 for a few minutes and at a temperature T2 above T1 for a few minutes, and further keeping the substrate at a given temperature above the above temperature for a given period of time are repeated. The difference in temperature in each state is generally 30 to 150°C, and the time for which the substrate is kept at the given temperature is generally 10 sec to 3 min for each temperature. The effect of the present invention can be significantly developed by prebaking under such conditions.

For example, in the case of prebaking in a two-stage temperature manner, when the second-stage prebaking temperature (highest prebaking temperature) is A(°C), the first-stage prebaking temperature is preferably in the range of (1/4)A to (3/4)A(°C).

For example, in the case of prebaking in a three-stage temperature manner, when the third-stage prebaking temperature (highest prebaking temperature) is A(°C), the first-stage prebaking temperature is preferably in the range of (1/4)A to (5/8)A(°C) while the second-stage prebaking temperature is preferably in the range of (5/8)A to (7/8)A(°C).

For example, when a solvent having a boiling point of about 150°C such as xylene is used in the polysilazane solution and, at the same time, a temperature of 200°C is selected as the highest prebaking temperature, (a) in the case of prebaking in a two-stage temperature manner, the first-stage prebaking temperature is preferably in the range of 50 to 150°C, and (b) in the case of prebaking in a three-stage temperature manner, the first-stage prebaking temperature is 50 to 125°C while the second-stage prebaking temperature is preferably in the range of 125 to 175°C.

Specifically, also in the method for raising the temperature stepwise, multistage temperature setting is carried out so that, in the whole prebaking step, the temperature reaches the target temperature by a gradual temperature rise.

Further, in the method in which the temperature is raised monotonically, the temperature rise should be 0°C or above relative to the temperature of the point before that point. In this case, the difference in temperature between the current point and any point before the current point may be 0 (zero) but should not be negative. In other words, when the prebaking temperature is plotted against the time, the slope of the temperature curve should not be negative. Here the substrate temperature is generally raised at a temperature rise rate in the range of 0 to 500°C/min, preferably 10 to 300°C/min. When the temperature rise rate is higher, the contribution to the degree of process time shortening is larger. However, the temperature rise rate is preferably low from the viewpoints of satisfactorily removing the solvent present within the groove structure and realizing satisfactorily polymerization of polysilazane.

The expression "the temperature is controlled so that the temperature in the prebaking step is raised with time" does not include, for example, the case where a low-temperature substrate is transferred to high-temperature conditions and is rapidly raised to the same temperature as the atmosphere temperature and the substrate is prebaked while maintaining the substrate at that temperature. In this case, although the substrate temperature is raised with time, the temperature rise is not controlled and, in this case, in many cases, the effect of the present invention cannot be attained.

The temperature control in the prebaking step is carried out for preventing a rapid temperature rise in the coating film in the prebaking step and for raising the temperature at a lower temperature rise rate than prebaking by conventional single-stage heating. The reason why, for example, the voids within the groove are reduced by the method according to the present invention has not been fully elucidated yet, but is believed to reside in that, when the temperature of the substrate is rapidly raised, the surface is excessively cured before the solvent is completely removed from the interior of the trench isolation groove and, consequently, the vapor of the solvent stays within the groove. The present invention can solve the above problem by controlling the temperature in the prebaking step.

When the method according to the present invention is carried out in combination with the prebaking step, preferably, before the temperature is lowered, the substrate which has been brought to a high temperature by prebaking is subjected to the curing step in such a state that the temperature of the substrate is preferably 50°C or above and the highest temperature in the prebaking and a temperature below the highest temperature in the prebaking. When the substrate is subjected to the curing step before the temperature of the substrate is lowered, the energy and time necessary for raising the temperature again can be saved.

### (b) Polishing step

After the silicon-containing polymer coating film is cured, the cured silicon dioxide film in its unnecessary part is preferably removed. To this end, the polysilazane coating film provided on the surface of the substrate is first removed by polishing. This step is a polishing step. The polishing step may be carried out after the curing treatment. Alternatively, when the prebaking step is carried out in combination with the polishing step, the polishing step may be carried out immediately after prebaking.

The polishing is carried out by chemical mechanical polishing (hereinafter referred to as "CMP"). This polishing by CMP can be carried out by conventional polishing agent and polishing apparatus. Specifically, for example, an aqueous solution prepared by dispersing a polishing material such as silica, alumina, or ceria and optionally other additive may be used as a polishing agent. The polishing apparatus may be a commercially available conventional CMP apparatus.

### (c) Etching step

In the polishing step, the silicon dioxide film derived from the silicon-containing polymer on the surface of the substrate is mostly removed. In order to remove the remaining silicon dioxide film, preferably, etching treatment is further carried out. It is common practice to use an etching solution for the etching treatment. The etching solution is not particularly limited so far as the silicon dioxide film can be removed. In general, an aqueous hydrofluoric acid solution containing ammonium fluoride is used. The concentration of ammonium fluoride in this aqueous solution is preferably not less than 5%, more preferably not less than 30%.

When a silicon nitride film is formed on the silicon dioxide film adjacent directly to the surface of the substrate, subsequently to the etching step (c), the silicon nitride film is also removed by etching. The silicon nitride liner film formed within the groove is buried in the silicon dioxide and thus is not removed. Also in this etching treatment, it is common practice to use an etching solution. The etching solution is not particularly limited so far as the silicon nitride film can be removed. In general, however, an aqueous phosphoric acid solution having a concentration of not less than 70% is used, and the temperature is generally regulated to about 80°C.

### Base material with siliceous film

The base material with a siliceous film according to the present invention can be produced, for example, by the method for trench isolation structure formation. One of the features of the base material with a siliceous film is that at least partially oxidized silicon nitride liner film is provided between the siliceous film and the base material.

The partially oxidized silicon nitride liner film is formed by oxidizing the silicon nitride liner film simultaneously with the conversion of the silicon-containing polymer to silicon dioxide. It is considered that this oxidation causes expansion of the silicon nitride liner film that improves the densiness within the trench and can suppress the occurrence of structural defects. The oxiation degree of the partially oxidized silicon nitride liner film is not less than 1.0 nm from the outer surface, and the film thickness after the oxidation is not less than 1.3 times, more preferably not less than 1.5 times, the film thickness before the oxidation. When the polysilicon film is formed on the silicon nitride liner film, the polysilicon film may be oxidized partially or entirely, preferably entirely from the viewpoint of ensuring the insulating properties.

The oxidized silicon nitride liner film contains oxygen because of its partially oxidized state. When the oxygen content is high, the densiness within the trench is likely to be enhanced. However, excessive oxidation sometimes causes the silicon substrate per se to be oxidized, resulting in deteriorated device properties. In order to prevent this unfavorable phenomenon, complete oxidation of the silicon nitride liner film should be avoided. Specifically, the silicon nitride liner film is preferably not oxidized by a thickness of not less than 1 nm, more preferably not less than 2 nm, from the substrate.

The silicon nitride liner film is preferably thick from the viewpoint of preventing the oxidation of the substrate and the like. When the thickness of the silicon nitride liner film is excessively large, however, the formation of an even film, for example, within the groove is difficult. Accordingly, the thickness of the silicon nitride liner film before the oxidation is 8 to 50 nm, more preferably 10 to 30 nm.

The structure other than the structure of the silicon nitride liner film may be the same as the conventional base material with a siliceous film. Such structures are described, for example, in patent documents 1 and 2.

### EXAM PLES

The following Examples further illustrate the present invention.

### Preparation of polysilazane solution

Polysilazane solution A was prepared by the following method.
(1) Dichlorosilane (48 g) having a purity of 99% or higher was poured into 500 g of dehydrated pyridine of 0°C with stirring.
(2) Subsequently, ammonia (27 g) having a purity of 99.9% was poured into the solution with stirring over a period of three hr while holding the solution temperature at 0°C.
(3) After the completion of pouring of ammonia, the produced ammonium chloride was removed by filtration.
(4) The filtrate after the removal of ammonium chloride was heated to 50°C, and the remaining ammonia was removed. The filtrate contained a produced polysilazane having a weight average molecular weight of 2000.
(5) Xylene was mixed into the filtrate after the removal of ammonia, and the mixture was distilled at 50°C under a reduced pressure of 20 mmHg to remove pyridine and to regulate the polymer concentration to 20% by weight.
(6) The polymer solution thus obtained was purified by circulation filtration through a filter with a filtration accuracy of 0.1 µm. The number of particles having a size of not less than 0.2 µm contained in the polymer solution was measured with a particle counter KS40-BF manufactured by RION Co., Ltd. and was found to be 3 particles/cc.

### Preparation of silsesquioxane hydride solution

As described below, silsesquioxane hydride was prepared by a method described in patent document 3, and a silsesquioxane hydride solution B was prepared.
(1) Benzenesulfonic acid hydrate (50.0 g), 150.0 g of a 35% aqueous hydrochloric acid solution, and 650.0 g of toluene were placed in a one-liter three-necked flask, and 200 g of a solution of 25% by weight of trichlorosilane in toluene was added dropwise with stirring at 400 rpm over a period of 50 min. The mixture was stirred for additional two hr.
(2) This reaction product was poured into a separatory funnel, and the organic layer was separated. The separated organic layer was washed twice with 100 ml of 47% sulfuric acid and was then washed twice with 100 ml of deionized water. Subsequently, about 20 g of calcium carbonate was added to the organic layer, and the mixture was stirred for 10 min. Thereafter, about 20 g of magnesium sulfate was added thereto, and the mixture was stirred for 10 min. The solution was filtered, and the solvent was stripped from the filtrate. n-Hexane was added to 17.4 g of the solid to dissolve the resinous material, and the residual crystalline material was separated and recovered as a solid.
(3) The silsesquioxane hydride thus obtained was dissolved in xylene to prepare a solution having a polymer concentration of 20% by weight, and the solution was purified by circulation filtration through a filter with a filtration accuracy of 0.1 µm. The number of particles having a size of not less than 0.2 µm contained in the polymer solution was measured with a particle counter KS40-BF manufactured by RION Co., Ltd. and was found to be 3 particles/cc.

### Formation of trench isolation groove

Trench isolation grooves were formed in a silicon substrate as follows according to "second embodiment" in Patent No. 3178412.
(1) A silicon dioxide film was formed by thermal oxidation on a surface of a silicon substrate, and a silicon nitride film was formed on the silicon dioxide film by CVD.
(2) A photoresist was coated onto the formed silicon nitride film, and the assembly was exposed and developed by photolithography for patterning. The pattern was formed so that the final pattern is linear grooves of 1 µm, 0.05 µm, 0.1 µm, 0.2 µm, 0.5 µm, and 1 µm.
(3) The silicon nitride film and the silicon dioxide film were successively dry etched using the patterned photoresist film as a mask. Holes passed through the silicon nitride film and the silicon dioxide film were formed by the dry etching, and the silicon substrate was linearly exposed.
(4) The photoresist was removed, and the silicon nitride film was exposed. The silicon substrate was etched using the silicon nitride film as a mask to form a groove structure in the silicon substrate. Further, a silicon dioxide film was also formed within the groove by thermal oxidation. The formation of either a silicon nitride liner film or a silicon nitride liner film and a polysilicon film was then carried out by CVD on the whole substrate surface to form trench isolation grooves. In this case, when only the silicon nitride liner film was formed, the thickness of the silicon nitride liner film was 10 nm. On the other hand, when the silicon nitride liner film and the polysilicon film were formed, the thickness of the silicon nitride liner film and the thickness of the polysilicon film were 10 nm and 5 nm, respectively.

### Example 1

A trench isolation structure was formed by the following method in a silicon substrate having trench isolation grooves formed by the above method (a silicon substrate having a silicon nitride liner film thickness of 10 nm and not provided with a polysilicon film).
(1) Polysilazane solution A described above was coated onto the silicon substrate by spin coating under coating conditions of spinning speed 1000 rpm and spinning time 20 sec. When coating was carried out on a bare silicon substrate under the same conditions, the thickness of the coating was 600 nm.
(2) The coated substrate was prebaked by heating at 150°C for 3 min.
(3) After prebaking, the prebaked substrate was introduced into a cure oven under a pure oxygen atmosphere while maintaining the final temperature of the prebaking, was heated to 1050°C at a temperature rise rate of 10°C/min, and was heated under an oxygen atmosphere containing a steam concentration of 80% for 30 min for curing.
   For a film formed by coating the polysilazane solution on the bare silicon and curing the coating under the same conditions, the chemical structure was examined by FTIR. As a result, only absorption of an Si-O bond attributable to wavenumber 1080 cm⁻¹ was observed, neither absorption of N-H bond attributable to wavenumber 3380 cm⁻¹ nor absorption of S-H bond attributable to wavenumber of 2200 cm⁻¹ was observed, indicating that, in this state, the polysilazane as the starting material had been entirely converted to silicon dioxide.
(4) The silicon dioxide film on the surface of the silicon substrate was polished by CMP until the silicon nitride film was exposed.
(5) The silicon nitride film exposed on the surface was removed by etching with an aqueous phosphoric acid solution of 80°C.
(6) The silicon dioxide film was etched with an aqueous solution containing 30% by weight of ammonium fluoride and 1% of hydrofluoric acid to a position near the silicon substrate to form a trench isolation structure.

### Example 2

The procedure of Example 1 was repeated, except that polysilazane solution A was changed to silsesquioxane hydride solution B.

### Example 3

The procedure of Example 1 was repeated, except that the prebaking step in Example 1 was carried out by heating the coated substrate at 100°C, 150°C and 200°C successively each for 2 min.

### Example 4

The procedure of Example 3 was repeated, except that polysilazane solution A was changed to silsesquioxane hydride solution B.

### Example 5

The procedure of Example 3 was repeated, except that the heating temperature was changed to 1100°C.

### Example 6

The procedure of Example 5 was repeated, except that polysilazane solution A was changed to silsesquioxane hydride solution B.

### Example 7

The procedure of Example 3 was repeated, except that, instead of the silicon substrate used in Example 3, a silicon substrate comprising a 5 nm-thick polysilicon film provided on a 10 nm-thick silicon nitride liner film was used.

### Example 8

The procedure of Example 7 was repeated, except that polysilazane solution A was changed to silsesquioxane hydride solution B.

### Example 9

The procedure of Example 7 was repeated, except that the heating temperature was changed to 1100°C.

### Example 10

The procedure of Example 9 was repeated, except that polysilazane solution A was changed to silsesquioxane hydride solution B.

### Example 11

The procedure of Example 1 was repeated, except that the steam concentration was changed to 40% by weight.

### Example 12

The procedure of Example 1 was repeated, except that the thickness of the silicon nitride liner film was changed to 5 nm.

### Example 13

The procedure of Example 1 was repeated, except that the thickness of the silicon nitride liner film was changed to 2 nm.

### Comparative Example 1

The procedure of Example 1 was repeated, except that the silicon nitride liner film was not formed in the preparation of the silicon substrate having a trench isolation structure.

### Comparative Example 2

The procedure of Comparative Example 1 was repeated, except that polysilazane solution A was changed to silsesquioxane hydride solution B.

### Comparative Example 3

The procedure of Example 1 was repeated, except that, in the preparation of the silicon substrate having a trench isolation structure, a silicon oxide film was formed instead of the silicon nitride liner film.

### Comparative Example 4

The procedure of Comparative Example 3 was repeated, except that polysilazane solution A was changed to silsesquioxane hydride solution B.

### Comparative Example 5

The procedure of Example 1 was repeated, except that the heating temperature in the curing was changed to 800°C.

### Comparative Example 6

The procedure of Example 2 was repeated, except that the heating temperature in the curing was changed to 800°C.

### Evaluation

The following evaluation was carried out for the substrates having a trench isolation structure prepared in each Example.
(1) The state of the substrate surface was observed under an electron scanning microscope (hereinafter referred to as "SEM") for visual evaluation of the smoothness of the trench part.
(2) The substrate was cut in a direction perpendicular to the longitudinal direction of the groove, was immersed in an aqueous solution containing 0.5% by weight of hydrofluoric acid and 5% by weight of ammonium fluoride at 23°C for 30 sec, was then well washed with pure water, and was dried. The groove part in the cross section was observed under SEM at a magnification of 50000 times from above at an elevation angle of 30 degrees to the direction perpendicular to the cross section and was photographed. The ratio between the etching rate in the surface part in the cross section of the substrate and the etching depth in the surface part of the cross section of the substrate and the deepest part of the groove was calculated based on the length on the photograph by trigonometry.
   When the siliceous film within the groove is even, the above ratio is close to 1. When the densiness of the siliceous film in the deepest part of the groove is low, the above ratio is lower than 1.
(3) For the substrate in each Example, the thickness of the silicon nitride liner film not subjected to oxidation was measured by observation under SEM. The thickness of the silicon nitride liner film in its oxidized part, the thickness of the silicon dioxide film derived from the silicon nitride liner film after the oxidation, and the coefficient of thermal expansion of the silicon nitride liner film were determined by this measurement.

The results were as shown in Tables 1 to 4.

### [Table 1]

**Table 1 Visual evaluation of substrate surface**

| Trench width | 0.05 µm | 0.1 µm | 0.2 µm | 0.5 µm | 1 µm |
|---|---|---|---|---|---|
| Example 1 | ⊚ | ⊚ | ⊚ | ⊚ | ⊚ |
| Example 2 | ○ | ○ | ⊚ | ⊚ | ⊚ |
| Example 3 | ⊚ | ⊚ | ⊚ | ⊚ | ⊚ |
| Example 4 | ○ | ○ | ⊚ | ⊚ | ⊚ |
| Example 5 | ⊚ | ⊚ | ⊚ | ⊚ | ⊚ |
| Example 6 | ○ | ○ | ⊚ | ⊚ | ⊚ |
| Example 7 | ⊚ | ⊚ | ⊚ | ⊚ | ⊚ |
| Example 8 | ○ | ○ | ⊚ | ⊚ | ⊚ |
| Example 9 | ⊚ | ⊚ | ⊚ | ⊚ | ⊚ |
| Example 10 | ○ | ○ | ⊚ | ⊚ | ⊚ |
| Example 11 | ○ | ○ | ⊚ | ⊚ | ⊚ |
| Comparative Example 1 | ×× | ×× | ×× | ×× | ×× |
| Comparative Example 2 | ×× | ×× | ×× | ×× | ×× |
| Comparative Example 3 | ×× | ×× | ×× | ×× | ×× |
| Comparative Example 4 | ×× | ×× | ×× | ×× | ×× |
| Comparative Example 5 | × | × | Δ | Δ | Δ |
| Comparative Example 6 | × | × | Δ | Δ | Δ |

| | | | | | |
|---|---|---|---|---|---|
| Evaluation criteria ⊚: Smooth surface ○ : Smoothness maintained although slight separation was observed. Δ: Separation was slightly observed. ×: Immeasurable due to severe separation ××: Deformed trench shape due to oxidation of substrate | | | | | |

### [Table 2]

**Table 2 Evaluation of substrate etching**

| | Etching rate, nm/min | Deepest part ot groove in each trench width/surface etching rate ratio | | | | |
|---|---|---|---|---|---|---|
| | | 0.05 µm | 0.1 µm | 0.2 µm | 0.5 µm | 1 µm |
| Example 1 | 10 | 1.0 | 1.0 | 1.0 | 1.0 | 1.0 |
| Example 2 | 12 | 1.2 | 1.1 | 1.1 | 1.0 | 1.0 |
| Example 3 | 9 | 1.0 | 1.0 | 1.0 | 1.0 | 1.0 |
| Example 4 | 10 | 1.1 | 1.1 | 1.1 | 1.0 | 1.0 |
| Example 5 | 80 | 1.0 | 1.0 | 1.0 | 1.0 | 1.0 |
| Example 6 | 10 | 1.1 | 1.1 | 1.1 | 1.0 | 1.0 |
| Example 7 | 80 | 1.0 | 1.0 | 1.0 | 1.0 | 1.0 |
| Example 8 | 9 | 1.1 | 1.1 | 1.1 | 1.0 | 1.0 |
| Example 9 | 7 | 1.0 | 1.0 | 1.0 | 1.0 | 1.0 |
| Example 10 | 9 | 1.1 | 1.0 | 1.0 | 1.0 | 1.0 |
| Example 11 | 15 | 1.1 | 1.1 | 1.1 | 1.0 | 1.0 |
| Example 12 | 10 | 1.0 | 1.0 | 1.0 | 1.0 | 1.0 |
| Example 13 | 10 | 1.0 | 1.0 | 1.0 | 1.0 | 1.0 |
| Comparative Example 1 | 10 | 1.0 | 1.0 | 1.0 | 1.0 | 1.0 |
| Comparative Example 2 | 11 | 1.1 | 1.1 | 1.1 | 1.0 | 1.0 |
| Comparative Example 3 | 10 | 1.0 | 1.0 | 1.0 | 1.0 | 1.0 |
| Comparative Example 4 | 11 | 1.1 | 1.1 | 1.1 | 1.0 | 1.0 |
| Comparative Example 5 | 28 | Immeasurable | Immeas -urable | 3.5 | 2.8 | 1.3 |
| Comparative Example 6 | 30 | Immeasurable | Immeas -urable | 3.4 | 2.8 | 1.3 |

### [Table 3]

**Table 3 Coefficient of expansion of silicon nitride liner film after oxidation**

| | Degree of conversion of SiN to SiO₂ | | | Degree of increase in film thickness (nm) | Coefficient of expansion |
|---|---|---|---|---|---|
| | Thickness of unoxidized SiN film (nm) | Thickness of oxidized SiN film (nm) | Thickness of oxidized SiO₂ film (nm) | | |
| Example 1 | 3.0 | 7.0 | 13.4 | 6.4 | 1.64 |
| Example 2 | 3.5 | 6.5 | 12.4 | 5.9 | 1.59 |
| Example 3 | 3.5 | 6.5 | 12.4 | 5.9 | 1.59 |
| Example 4 | 3.5 | 6.5 | 12.4 | 5.9 | 1.59 |
| Example 5 | 2.0 | 8.0 | 15.3 | 7.3 | 1.73 |
| Example 6 | 2.0 | 8.0 | 15.3 | 7.3 | 1.73 |
| Example 11 | 6.0 | 4.0 | 7.6 | 3.6 | 1.36 |
| Comparative Example 5 | Oxidation of silicon nitride liner film was not observed. | | | | |

### [Table 4]

**Table 4 Coefficient of expansion derived from oxidation of silicon nitride liner film and polysilicon film**

| | Conversion of polysilicon to SiO₂ | Degree of increase in film thickness by polysilicon (nm) | Degree of conversion of SiN to SiO₂ | | | Degree of increase in thickness by SIN (nm) | Total degree of increase in film thickness (nm) | Coefficient of expansion |
|---|---|---|---|---|---|---|---|---|
| | | | Thickness of un-oxidized SiN film (nm) | Thickness of oxidized SiN film (nm) | Thickness of oxidized SiO₂ (nm) | | | |
| Example 7 | 100% | 5.8 | 7.5 | 2.5 | 4.8 | 2.3 | 8.1 | 1.54 |
| Example 8 | 100% | 5.8 | 7.5 | 2.5 | 4.8 | 2.3 | 8.1 | 1.54 |
| Example 9 | 100% | 5.8 | 6.5 | 3.5 | 6.7 | 3.2 | 9.0 | 1.60 |
| Example 10 | 100% | 5.8 | 7.0 | 3.0 | 5.7 | 2.7 | 8.5 | 1.57 |
| Compa-rative Example 6 | For neither silicon nitride liner film nor polysilicon film, oxidation was observed. | | | | | | | |

The polysilicon film was in an entirely oxidized state, and the silicon nitride liner film was also in an oxidized state.

## Claims

1. A method for forming a trench isolation structure, comprising the steps of:
forming, on a silicon substrate, a trench isolation groove or trench isolation grooves having a surface continuously coated with a silicon nitride liner film;
coating the substrate with a solution of a silicon-containing polymer, selected from the group consisting of polysilazanes, silsesquioxane hydrides, and mixtures thereof, in an organic solvent to form a silicon-containing polymer film; and
curing by heat treating the coated substrate at a temperature of from 1000°C to 1200°C to convert the silicon-containing polymer film to a silicon dioxide film, **characterized in that** the thickness of the silicon nitride liner film is 8 to 50 nm, wherein at least part of the silicon nitride liner film is oxidized up to no less than 1.0 nm from the surface of the silicon nitride liner film on its side not in contact with the substrate, and wherein the thickness of the silicon nitride liner film is increased by 1.3 times or more by the heat treatment.

2. The method for trench isolation structure formation according to claim 1, wherein the heating treatment is carried out in an inert gas or oxygen atmosphere having a steam concentration of not less than 50%.

3. The method for trench isolation structure formation according to claim 1 or 2, which further comprises a step of prebaking the coated substrate at a temperature of 400°C or below prior to the heat treatment.

4. The method for trench isolation structure formation according to any one of claims 1 to 3, wherein a polysilicon film is formed on the silicon nitride liner film by CVD.

## Patentansprüche

1. Verfahren zur Bildung einer Grabenisolationsstruktur, umfassend die Schritte:
Bilden, auf einem Siliciumsubstrat, einer Grabenisolationsrille oder von Grabenisolationsrillen mit einer Oberfläche, die durchgehend mit einer Siliciumnitridträgerfolie beschichtet ist;
Beschichten des Substrats mit einer Lösung eines Silicium-enthaltenden Polymers, ausgewählt aus der Gruppe bestehend aus Polysilazanen, Silsesquioxanhydriden, und Mischungen davon, in einem organischen Lösungsmittel, um einen Silicium-enthaltenden Polymerfilm zu bilden; und
Härten durch Hitzebehandlung des beschichteten Substrats bei einer Temperatur von 1000°C bis 1200°C, um den Silicium-enthaltenden Polymerfilm in einen Siliciumdioxidfilm umzuwandeln, **dadurch gekennzeichnet, dass** die Dicke der Siliciumnitridträgerfolie 8 bis 50 nm ist, wobei mindestens Teil der Siliciumnitridträgerfolie bis zu nicht weniger als 1,0 nm von der Oberfläche der Siliciumnitridträgerfolie auf deren Seite, die nicht in Kontakt mit dem Substrat ist, oxidiert wird, und wobei die Dicke der Siliciumnitridträgerfolie durch die Wärmebehandlung um 1,3 mal oder mehr erhöht wird.

2. Verfahren zur Grabenisolationsstrukturbildung gemäß Anspruch 1, wobei die Wärmebehandlung in einer Inertgas- oder Sauerstoffatmosphäre mit einer Dampfkonzentration von nicht weniger als 50 % durchgeführt wird.

3. Verfahren zur Grabenisolationsstrukturbildung gemäß Anspruch 1 oder 2, welches des Weiteren einen Schritt des Vorbrennens des beschichteten Substrats bei einer Temperatur von 400°C oder darunter vor der Wärmebehandlung umfasst.

4. Verfahren zur Grabenisolationsstrukturbildung gemäß einem der Ansprüche 1 bis 3, wobei ein Polysiliciumfilm auf der Siliciumnitridträgerfolie durch CVD gebildet wird.

## Revendications

1. Procédé de formation d'une structure d'isolation de tranchée, comprenant les étapes de :
formation, sur un substrat en silicium, d'une rainure d'isolation de tranchée ou de rainures d'isolation de tranchée ayant une surface revêtue de manière continue par un film de revêtement protecteur en nitrure de silicium ;
revêtement du substrat par une solution d'un polymère contenant du silicium, choisi dans le groupe constitué par les polysilazanes, les hydrures de silsesquioxane et les mélanges correspondants, dans un solvant organique pour former un film polymère contenant du silicium ; et
durcissement par traitement thermique du substrat revêtu à une température de 1000°C jusqu'à 1200°C pour convertir le film polymère contenant du silicium en un film de dioxyde de silicium, **caractérisé en ce que** l'épaisseur du film de revêtement protecteur en nitrure de silicium est de 8 jusqu'à 50 nm, au moins une partie du film de revêtement protecteur en nitrure de silicium étant oxydée jusqu'à une profondeur supérieure ou égale à 1,0 nm à partir de la surface du film de revêtement en nitrure de silicium sur la face n'étant pas en contact avec le substrat et l'épaisseur du film de revêtement protecteur en nitrure de silicium étant augmentée d'1,3 fois ou plus par le traitement thermique.

2. Procédé de formation d'une structure d'isolation de tranchée selon la revendication 1, le traitement thermique étant mis en oeuvre dans une atmosphère de gaz inerte ou d'oxygène ayant une concentration en vapeur d'eau supérieure ou égale à 50%.

3. Procédé de formation de structure d'isolation de tranchée selon la revendication 1 ou 2, comprenant en outre une étape de pré-cuisson du substrat revêtu à une température inférieure ou égale à 400°C préalablement au traitement thermique.

4. Procédé de formation de structure d'isolation de tranchée selon l'une quelconque des revendications 1 à 3, un film de polysilicium étant formé sur le film de revêtement protecteur en nitrure de silicium par CVD (dépôt chimique en phase vapeur).
